Europäisches Patentamt

European Patent Office

Office européen des brevets

(11) Numéro de publication: **0 511 078 B1**

## FASCICULE DE BREVET EUROPEEN

(45) Date de publication de fascicule du brevet: **05.04.95**

(51) Int. Cl.⁶: **G01D 5/16**, G01D 5/246, G01R 7/08

(21) Numéro de dépôt: **92401119.0**

(22) Date de dépôt: **21.04.92**

(54) **Dispositif de commande de logomètre.**

(30) Priorité: **25.04.91 FR 9105117**

(43) Date de publication de la demande:
**28.10.92 Bulletin 92/44**

(45) Mention de la délivrance du brevet:
**05.04.95 Bulletin 95/14**

(84) Etats contractants désignés:
**DE IT**

(56) Documents cités:
**EP-A- 0 255 772
DE-A- 3 634 052
US-A- 4 924 178**

(73) Titulaire: **SOCIETE D'APPLICATIONS GENERA-
LES D'ELECTRICITE ET DE MECANIOUE SA-
GEM
6, Avenue d'Iéna
F-75783 Paris Cédex 16 (FR)**

(72) Inventeur: **Levesque, Xavier
9 Grand Place
F-95000 Cergy (FR)**

(74) Mandataire: **Bloch, Gérard et al
2, square de l'Avenue du Bois
F-75116 Paris (FR)**

## Description

La présente invention concerne un procédé et un dispositif de commande d'un logomètre.

Il est usuel à l'heure actuelle d'utiliser comme indicateur, par exemple de jauge ou de température, des dispositifs à logomètre formés par exemple de deux enroulements en forme de cadre disposés à 90 degrés, à l'intérieur desquels une pastille magnétique est montée mobile en rotation et solidaire de l'aiguille de l'indicateur. Un courant électrique parcourant chacune des bobines, il en résulte un champ magnétique résultant sur lequel s'aligne la pastille magnétique, déplaçant ainsi l'aiguille de l'indicateur.

On utilise généralement pour faire varier le rapport des courants électriques dans les deux enroulements une résistance variable connectée aux bornes du logomètre. Cette résistance variable peut être par exemple une thermistance, dans le cas où il s'agit de mesurer des températures ou un rhéostat, dans le cas où il s'agit d'un indicateur de niveau.

On verra ci-après que différents montages électriques sont possibles pour les deux enroulements.

La connexion directe du capteur aux bornes du logomètre présente les avantages d'être particulièrement simple et de présenter la propriété intéressante d'une invariance de l'indication angulaire du logomètre par rapport à la tension d'alimentation pour un rapport donné des courants. Or, on sait que dans une automobile, par exemple, cette tension d'alimentation doit pouvoir varier de 10,5 volts à 16 volts.

Il existe cependant des applications dans lesquelles il n'est plus possible de connecter directement le capteur au logomètre. C'est en particulier le cas lorsque plusieurs capteurs sont reliés à un microprocesseur programmé pour élaborer des paramètres fonctions des mesures des différents capteurs.

On peut citer comme exemple le cas où le microprocesseur doit calculer l'autonomie instantanée du véhicule en fonction non seulement des indications de la jauge à essence, mais également de divers paramètres de fonctionnement du moteur.

Dans ce cas, le capteur n'est plus directement accessible pour sa connexion au logomètre et il est nécessaire de passer par l'intermédiaire du calculateur.

Un dispositif selon le préambule de la revendication 1, tel que décrit dans le document US-A-4 924 178, permet une telle commande.

Dans ce document on applique à l'entrée du logomètre, par l'intermédiaire d'un calculateur, un signal par impulsions, et notamment un signal rectangulaire, représentatif d'une grandeur physique à mesurer.

Plus particulièrement, le signal rectangulaire peut être un signal à fréquence constante modulé en largeur d'impulsions.

On peut montrer que l'on conserve alors la propriété d'invariance de l'indication angulaire par rapport à la tension d'alimentation du logomètre.

Ces dispositifs présentent toutefois l'inconvénient de ne pas tenir compte du fait que la valeur de la grandeur physique en sortie du capteur ne varie pas de 0 à l'infini, mais d'une valeur minimale à une valeur maximale. Ils ne disposent donc pas de l'échelle de mesure maximale possible.

La présente invention vise à pallier à cet inconvénient.

A cet effet, elle a pour objet un dispositif selon la revendication 1.

L'interrupteur est de préférence commandé par le calculateur par l'intermédiaire d'un circuit de codage de largeur d'impulsions.

Le calculateur peut notamment être un calculateur numérique relié à un capteur analogique par l'intermédiaire d'un convertisseur analogique/numérique.

Lorsque ladite grandeur physique à mesurer est la valeur d'une résistance électrique variable alimentée par un générateur de courant, on règle de préférence ce dernier de telle sorte que la tension aux bornes de la résistance, lorsque la valeur de cette dernière est maximale, soit égale à la tension maximale codable en entrée du calculateur.

Cet agencement permet de bénéficier de la précision maximale. Bien entendu, un réglage similaire peut également être effectué lorque le capteur n'est pas un capteur résistif.

On décrira maintenant à titre d'exemple non limitatif des modes de réalisation particuliers de l'invention en référence aux dessins schématiques annexés dans lesquels :

- les figures 1 et 2 représentent un dispositif selon l'invention connecté à des logomètres de deux types différents.
- la figure 3 représente plus en détail le dispositif selon l'invention et,
- les figures 4 et 5 représentent deux circuits possibles de correction d'échelle.

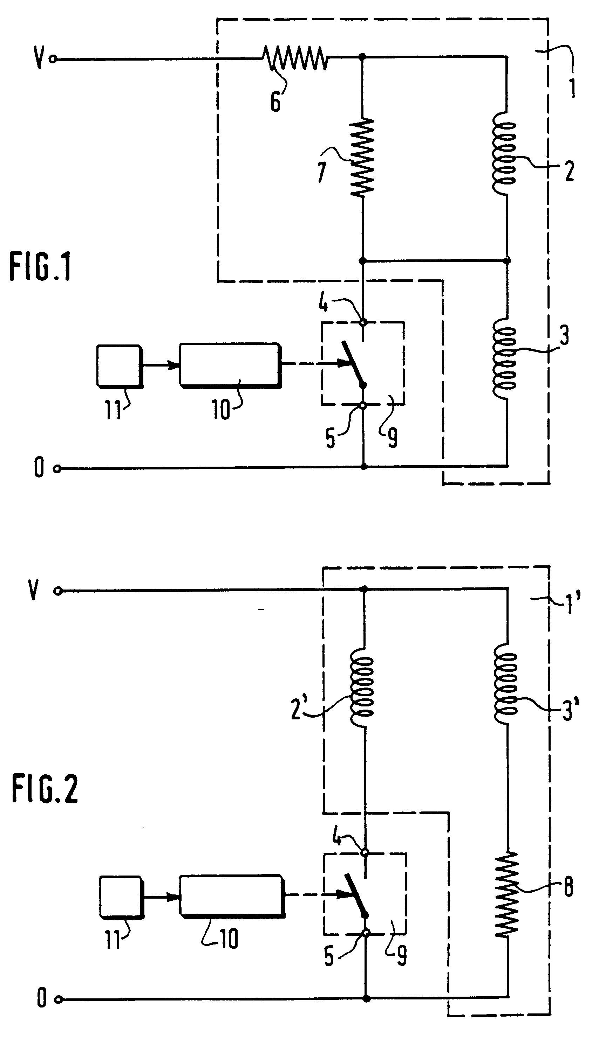

Si l'on se réfère maintenant à la figure 1, on voit en 1 un logomètre de type I. Dans un tel logomètre, les enroulements 2 et 3 sont connectés en série, les bornes d'entrée 4 et 5 du logomètre étant constituées par les bornes de l'enroulement 3. Des résistances 6 et 7 permettent de régler le courant total dans le logomètre en fonction de la tension d'alimentation V ainsi que le rapport des courants dans les enroulements 2 et 3.

A la figure 2, on a représenté en 1' un logomètre de type II. Dans ce cas, les bobines 2' et 3' sont montées en parallèle et les bornes d'entrée 4 et 5 du logomètre sont en série avec la bobine 2'. Une résistance 8 permet d'effectuer le réglage des courants.

On connecte dans les deux cas aux bornes 4, 5 du logomètre un interrupteur électronique 9, par exemple un transistor, commandé par un calculateur 10.

Le calculateur 10 reçoit lui-même en entrée une tension représentative d'une grandeur physique mesurée par un capteur 11.

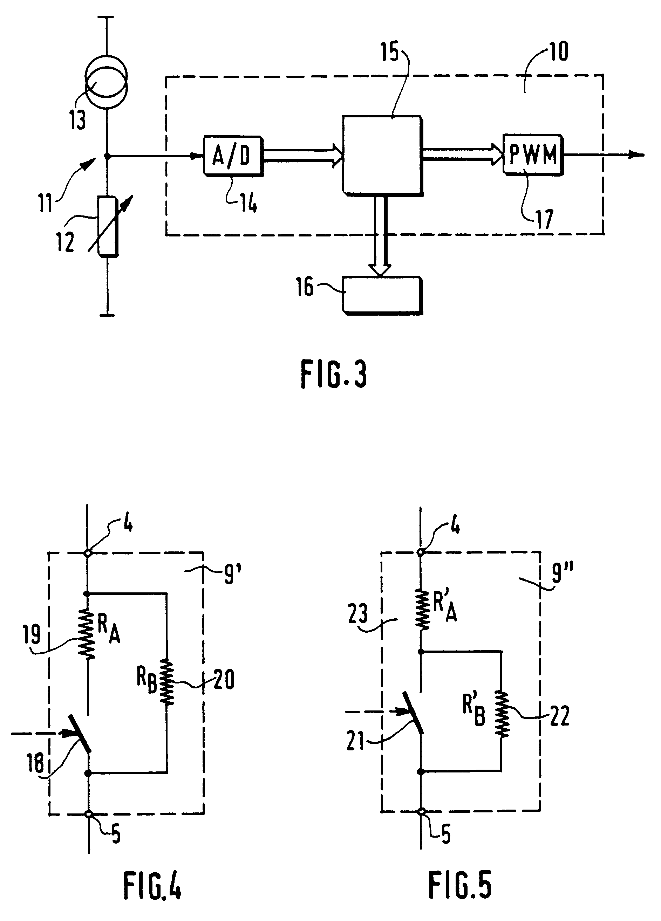

Si l'on se réfère maintenant à la figure 3, on voit que le capteur 11 est constitué par une résistance variable, par exemple une thermistance ou un rhéostat, alimentée par un générateur de courant 13, comme cela est connu en soi par le document DE-A-3634052.

La tension aux bornes de la résistance 12, proportionnelle à la valeur de cette résistance, est convertie dans un convertisseur analogique/numérique 14 dont la sortie est fournie en entrée à une unité de calcul 15.

L'unité de calcul 15 reçoit également les signaux de sortie d'autres capteurs pour élaborer des paramètres composés, par exemple de consommation ou d'autonomie, qui peuvent être affichés sur un indicateur 16. Le calculateur 15 peut également apporter des corrections à la valeur mesurée par le capteur 11. Le calculateur 15 fournit en sortie à un circuit de codage de largeur d'impulsions 17 la valeur à faire afficher par le logomètre.

Le circuit 17 élabore de façon connue un signal rectangulaire de fréquence constante et de lageur d'impulsions variable.

On peut montrer que si cette fréquence est grande par rapport à la bande passante du logomètre, la déviation angulaire de ce dernier sera une fonction du rapport de la largeur des impulsions à la période du signal, indépendante de la tension d'alimentation du logomètre. En effet, dans les deux cas des figures 1 et 2, le rapport des intensités dans les bobines 2 et 3 ou 2' et 3' n'est fonction que des valeurs des résistances des différents composants et du rapport précité entre la période du signal et la largueur des impulsions.

A titre d'exemple, le signal délivré par le circuit 17 peut avoir une fréquence de 200 hertz pour une constante de temps du logomètre de 2 secondes.

Le dispositif selon l'invention simule par conséquent à l'entrée du logomètre la résistance 12 du capteur.

En fait, cette résistance ne varie pas de 0 à l'infini mais d'une valeur minimale à une valeur maximale. Pour conserver la meilleure précision possible, on remplace l'interrupteur électronique 9 par l'interrupteur 9' de la figure 4 ou l'interrupteur 9'' de la figure 5.

Dans le cas de la figure 4, l'interrupteur 18 proprement dit est monté en série avec une résistance 19 de valeur $R_A$, l'ensemble de l'interrupteur 18 et de la résistance 19 étant monté en parallèle avec une résistance 20 de valeur de $R_B$ aux bornes 4 et 5 du logomètre.

Si $R_m$ est la plus petite valeur possible de la résistance 12 et $R_M$ sa valeur la plus grande possible, on choisira alors $R_A$ et $R_B$ de façon que :

$$R_B = R_M$$

et

$$\frac{R_A \quad R_B}{R_A + R_B} = R_m$$

Dans le cas de la figure 5, l'interrupteur électronique proprement dit 21 est monté en parallèle avec une résistance 22 de valeur $R'_B$ , l'ensemble de l'interrupteur 21 et de la résistance 22 étant monté en série avec une résistance 23 de valeur $R'_A$ aux bornes 4 et 5 du logomètre.

Dans cas, on choisira $R'_A$ et $R'_B$ de façon que :

$$R'_A + R'_B = R_M$$

et

$$R'_A = R_m$$

On constatera aisément que dans les deux cas la résistance simulée entre les bornes 4 et 5 d'entrée du logomètre varie entre $R_m$ et $R_M$ lorsque le rapport de la largeur des impulsions à la période du signal issu du circuit 17 varie de 0 à 1.

**Revendications**

1. Dispositif de commande d'un logomètre (1 ; 1'), comprenant un interrupteur électronique (9 ; 9' ; 9'') connecté aux bornes d'entrée (4, 5) du logomètre et commandé par un calculateur (10) qui reçoit à l'entrée une tension réprésentative d'une grandeur physique mesurée par un capteur dont la valeur correspondante varie entre deux valeurs extrêmes respectivement minimale $R_m$ et maximale $R_M$, caractérisé par le fait que l'interrupteur est associé à un circuit de correction d'échelle (18-20 ; 21-23) agencé de telle sorte que ce circuit de correction présente avec l'interrupteur constamment ouvert une desdites valeurs extrêmes du capteur et avec l'interrupteur constamment fermé l'autre valeur extrême.

2. Dispositif selon la revendication 1, dans lequel l'interrupteur est monté en série avec une première résistance (19) de valeur $R_A$, l'ensemble de l'interrupteur et de la première résistance étant monté en parallèle avec une deuxième résitance (20) de valeur $R_B$ aux bornes du logomètre, $R_A$ et $R_B$ étant choisies telles que

$$R_B = R_M$$

$$\frac{R_A R_B}{R_A + R_B} = R_m$$

3. Dispositif selon la revendication 1, dans lequel l'interrupteur est monté en parallèle avec une première résistance (22) de valeur $R'_B$, l'ensemble de l'interrupteur et de la première résistance étant monté en série avec une deuxième résistance (23) de valeur $R'_A$ aux bornes du logomètre, $R'_A$ et $R'_B$ étant choisies telles que

$$R'_A = R_m$$
$$R'_A + R'_B = R_M$$

4. Dispositif selon l'une quelconque des revendications 1 à 3, dans lequel l'interrupteur est commandé par le calculateur par l'intermédiaire d'un circuit (17) de codage de largeur d'impulsions.

5. Dispositif selon l'une quelconque des revendications 1 à 4, dans lequel le calculateur est un calculateur numérique relié à un capteur analogique (11) par l'intermédiaire d'un convertisseur analogique/numérique (14).

6. Dispositif selon la revendication 5, dans lequel le capteur est un capteur résistif alimenté par un générateur de courant (13).

7. Dispositif selon la revendication 6, dans lequel le générateur de courant est réglé de telle sorte que la tension aux bornes de la résistance lorsque la valeur de cette dernière est maximale, soit égale à la tension maximale codable en entrée du calculateur.

## Claims

1. Device for controlling a logometer (1;1'), comprising an electronic switch (9;9';9'') connected to the input terminals (4, 5) of the logometer and controlled by a computer (10) which receives at the input a voltage representative of a physical quantity measured by a sensor whereof the corresponding value varies between two extreme values respectively a minimum value $R_m$ and a maximum value $R_M$, characterised by the fact that the switch is associated with a scale correction circuit (18-20; 21-23) arranged so that this correction circuit has, with the switch constantly open, one of said extreme values of the sensor and with the switch constantly closed the other extreme value.

2. Device according to claim 1, in which the switch is connected in series with a first resistor (19) having a value $R_A$, the arrangement of the switch and of the first resistor being connected, in parallel with a second resistor (20) having a value $R_B$, to the terminals of the logometer, $R_A$ and $R_B$ being chosen such that

$$R_B = R_M$$

$$\frac{R_A R_B}{R_A + R_B} = R_m$$

3. Device according to claim 1, in which the switch is connected in parallel with a first resistor (22) having a value $R'_B$, the arrangement of the switch and of the first resistor being connected in series, with a second resistor (23) having a value $R'_A$, to the terminals of the logometer, $R'_A$ and $R'_B$ being chosen such that

$$R'_A = Rm$$
$$R'_A + R'_B = R_M$$

4. Device according to one of claims 1 to 3, in which the switch is controlled by the computer by means of a pulse width coding circuit (17).

5. Device according to one of claims 1 to 4, in which the computer is a digital computer connected to an analog sensor (11) by means of an analog-to-digital converter (14).

6. Device according to claim 5, in which the sensor is a resistive sensor fed by a current generator (13).

7. Device according to claim 6, in which the current generator is set so that the voltage at the terminals of the resistor is equal, when the value of the latter is maximum, to the maximum voltage which can be coded at the input of the computer.

**Patentansprüche**

1.  Steuervorrichtung für einen Quotientenmesser (1; 1'), umfassend einen elektronischen Schalter (9; 9'; 9''), der mit den Eingangsanschlüssen (4, 5) des Quotientenmessers verbunden ist und durch einen Rechner (10) gesteuert wird, welcher an seinem Eingang eine Spannung erhält, die für eine durch einen Aufnehmer gemessene physikalische Größe repräsentativ ist, deren entsprechender Wert zwischen zwei Extremwerten variiert, einem Minimalwert $R_m$ und einem Maximalwert $R_M$, dadurch gekennzeichnet, daß der Schalter einer Meßbereichskorrekturschaltung (18-20; 21-23) zugeordnet ist, die so eingerichtet ist, daß diese Korrekturschaltung, wenn der Schalter ständig offen ist, einen dieser Extremwerte des Aufnehmers darstellt, und wenn der Schalter ständig geschlossen ist, den anderen der Extremwerte.

2.  Vorrichtung nach Anspruch 1, dadurch gekennzeichnet, daß der Schalter mit einem ersten Widerstand (19) des Wertes $R_A$ in Reihe geschaltet ist, wobei die Einheit aus Schalter und erstem Widerstand mit einem zweiten Widerstand (20) des Wertes $R_B$ an den Anschlüssen des Quotientenmessers parallel angeschlossen sind, und wobei $R_A$ und $R_B$ so gewählt sind, daß

$$R_B = R_M$$

$$\frac{R_A \; R_B}{R_A \; + \; R_B} \; = \; R_m$$

3.  Vorrichtung nach Anspruch 1, dadurch gekennzeichnet, daß der Schalter mit einem ersten Widerstand (22) des Wertes $R'_B$ parallel geschaltet ist, wobei die Einheit aus Schalter und erstem Widerstand mit einem zweiten Widerstand (23) des Wertes $R'_A$ an den Anschlüssen des Quotientenmessers in Reihe angeschlossen sind, und wobei $R'_A$ und $R'_B$ so gewählt sind, daß

$$R'_A = R_m$$
$$R'_A + R'_B = R_M.$$

4.  Vorrichtung nach einem der Ansprüche 1 bis 3, dadurch gekennzeichnet, daß der Schalter durch den Rechner unter Zwischenschaltung eines Impulsbreitenkodierungskreises (17) gesteuert wird.

5.  Vorrichtung nach einem der Ansprüche 1 bis 4, dadurch gekennzeichnet, daß der Rechner ein numerischer Rechner ist, der unter Zwischenschaltung eines Analog/Numerikwandlers (14) an einem Analogaufnehmer (11) angeschlossen ist.

6.  Vorrichtung nach Anspruch 5, dadurch gekennzeichnet, daß der Aufnehmer ein Widerstandsaufnehmer ist, der von einem Stromerzeuger (13) gespeist wird.

7.  Vorrichtung nach Anspruch 6, dadurch gekennzeichnet, daß der Stromerzeuger so bestimmt , daß die Spannung an den Anschlüssen des Widerstands, wenn dessen Größe maximal ist, gleich der maximalen kodierbaren Spannung am Eingang des Rechners ist.

FIG.1

FIG.2

FIG.3

FIG.4

FIG.5